# EUROPEAN PATENT APPLICATION

(11) **EP 0 731 493 A2**
(43) Date of publication of application: **11.09.1996**
(21) Application number: 96300326.4
(22) Date of filing: 17.01.1996
(51) Int. Cl.: H01L 21/205, H01L 21/20

(54) **Method for formation of a polycrystalline semiconductor film**

(30) Priority: 09.02.1995 US 386032; 27.12.1995 US 548807
(71) Applicant: APPLIED KOMATSU TECHNOLOGY, INC., Shinjuku, Tokyo (JP); SEIKO EPSON CORPORATION, Tokyo 163-08 (JP)
(72) Inventor: Law, Kam S., Union City, California 94587 (US); Kakimoto, Masao, Kanagawa 259-01 (JP); Robertson, Robert, Menlo Park, California 94025 (US); Miyasaka, Mitsutoshi, Nagano 392 (JP)
(74) Representative: Allard, Susan Joyce

(57) **Abstract**

A method of forming a crystalline semiconductor film on an insulating material of a substrate, the substrate at least having the insulating material as a portion of its surface. The crystalline semiconductor film is produced with a simple low-temperature process and improved in quality. A mixed crystal semiconductor film with a high crystalline is formed according to a PECVD method using silane as a raw material gas and argon as a diluting gas, and laser irradiation is made to the mixed crystal semiconductor film to improve the crystalline.

## Description

The present invention relates to a thin-film semiconductor device applicable to an active matrix type liquid crystal display and others and a crystalline semiconductor film applicable to a solar battery and others.

Recently, as in a liquid crystal display (LCD) its screen enlarges and its resolution increases, the driving type shifts from a matrix type to an active matrix type which can display a large amount of information. The active matrix type can produce a a liquid crystal display having several hundred thousand pixels, where a switching transistor is produced for each pixel. As a substrate for various liquid crystal displays, there is employed a transparent insulating substrate such as a molten quartz or a glass which permits the production of a transparent type display. In general, a semiconductor film such as an amorphous silicon (which will hereinafter be referred to as a-Si) film and a polycrystal silicon (which will hereinafter be referred to as poly-Si) film is used as an active layer of a thin-film transistor (TFT), while the polycrystal silicon is advantageous because of its high operating speed in a case where the thin-film transistor is formed to integrally includes an active circuit. For using the polycrystal silicon film as the active layer, a molten quartz is used as the substrate, and the TFT is produced in accordance with a so-called high-temperature process being a manufacturing method in which the maximum process temperature commonly exceeds 1000°C. In this instance, the mobility of the polycrystal silicon film assumes approximately 10 cm²·V⁻¹·s⁻¹ to 100 cm²·V⁻¹·s⁻¹. On the other hand, in a case where the amorphous silicon film is used as the active layer, an ordinary glass substrate is used, because the maximum process temperature is as low as approximately 400°C. The mobility of the amorphous silicon film assumes approximately 0.1 cm²·V⁻¹·s⁻¹ to 1 cm²·V⁻¹·s⁻¹.

In the case of enlarging the displaying screen of a LCD and lowering its manufacturing cost, in general the use of an inexpensive glass is indispensable. However, there is a problem that, as noted before, the amorphous silicon film is extremely inferior in electrical characteristic to the polycrystal silicon film and its operating speed is slow. In addition, since the high-temperature processed polycrystal silicon TFT is made of a molten quartz, there is a problem that difficulty is experienced in the enlargement and cost reduction of the LCD. For these reasons, currently there has strongly been desired a technique of producing a thin-film semiconductor device where a semiconductor film such as a polycrystal silicon film is formed as an active layer on an ordinary glass substrate. For using the ordinary glass substrate suitable for the mass-production, in order to avoid the deformation of the substrate, the maximum process temperature is limited to below approximately 400°C. Accordingly, there have been desired techniques of producing a thin-film transistor which is capable of operating a liquid crystal display under such a condition and further of producing an active layer of the thin-film transistor which is capable of operating a driving circuit at a high speed. These are now referred to as a low-temperature process poly-Si TFT which is under development. In this case, a serious problem is how to form a high-quality crystalline semiconductor film under the condition that the maximum process temperature (low-temperature process) is below approximately 400°C.

A first prior technique for formation of the poly-Si in the low-temperature process is the SID (Society for Information Display) shown in Digest, P. 389, (1993). According to this document, using the LPCVD technique, a monosilane (SiH₄) is used as the raw material gas and an amorphous silicon (a-Si) film with a thickness of 50 nm is deposited or accumulated at a deposit temperature of 550°C and is exposed to the laser irradiation so as to be changed into a higher-quality poly-Si film. Thus, according to this prior technique, the maximum process temperature is 550°C which allows the deposit of the a-Si film (which will hereinafter be referred to as an LPCVD a-Si) by the LPCVD method.

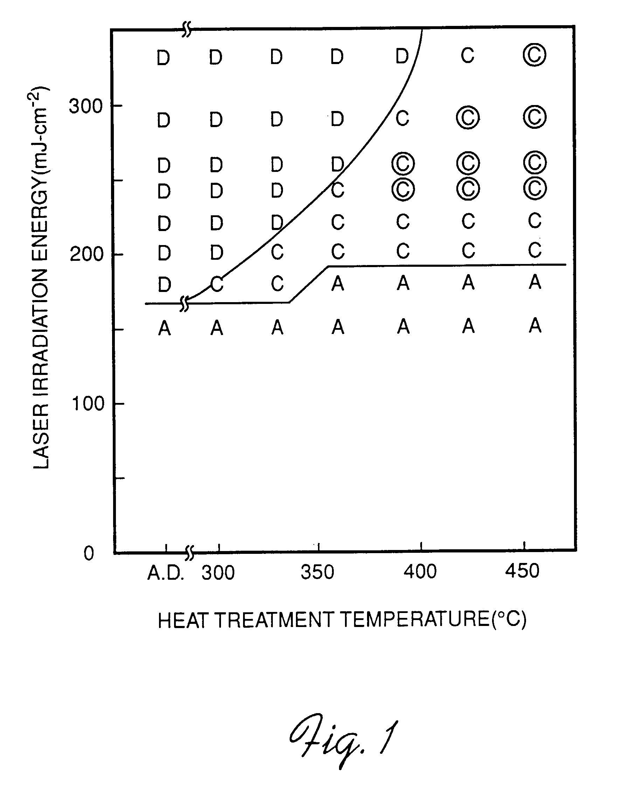

A second prior technique of forming the poly-Si film in the low-temperature process is typically exemplified by the Japanese Published Unexamined Patent Application No. 6-163401. The feature of this prior technique is that, although the aforesaid first prior technique uses the LPCVD a-Si, an a-Si film is deposited in accordance with the plasma CVD method (PECVD method) and then the deposited film is heat-treated at a temperature of approximately 300°C to 450°C (so-called hydrogen-removing annealing) before being subjected to a laser applying process to result in the formation of the poly-Si film. In fact, the statement of the paragraph [0033] of the same Patent Application is as follows. That is, a silicon oxide made passivation film 2 with a thickness of 200 nm and an amorphous silicon thin-film 3 with a thickness of 100 nm are formed on a glass substrate (coning 7059) 1 at a substrate temperature of 200°C in accordance with the plasma CVD method. Subsequently, they are heat-treated at a temperature of 300°C for 30 minutes, and further the amorphous silicon thin-film 3 is polycrystallized in such a way that light emitted from a 13-W argon laser is condensed to form a light spot with a diameter of approximately 50 µm and a scanning irradiation is made at a speed of approximately 11 m/second (scanning speed of beam spot diameter x 220000/second). As obvious from this example, for the crystallization of the a-Si film by the PECVD method (which will hereinafter be referred to as a PECVD a-Si), the heat treatment is indispensable before the crystalizing process. If the laser light is applied to the PECVD a-Si film with no heat treatment or in a state with a low temperature, when the irradiated laser energy intensity is weak, the crystallization does not advance at all. On the other hand, if the irradiated laser energy intensity is strong, the Si film can suffer from a damage, with the result that difficulty is completely encountered in the crystallization of the PECVD a-Si film. A description will be made of this state with reference to an experimental result shown in Fig. 1 and obtained by the Applicant. A specimen is an a-Si film deposited on a glass substrate (manufactured by Nippon Denki Garasu Co., Ltd, OA-2) by a parallel flat-plate type PECVD apparatus to have a thickness of 2500 angstroms. The film formation condition is that the flow rate of monosilane (SiH₄) is 225 SCCM, the flow rate of hydrogen (H₂) is 1300 SCCM, the RF output is 150W, the pressure is 1.3 torr, the electrode area is 1656 cm² (thus, the applied power density is 0.091 W/cm²), the distance between the electrodes is 24.4 mm, and the substrate temperature is 300°C. In this case, the formation speed of the PECVD a-Si film is 547 angstrom/min. This film is a typical PECVD a-Si film relying on the conventional technique, and contains approximately 10.3 atom% of hydrogen. The density of Si atom is 4.38 x 10²² cm⁻³. Fig. 1 shows the result for when the laser irradiation is made after the PECVD a-Si film is heat-treated for one hour in a nitrogen (N₂) atmosphere with a given temperature. In Fig. 1, the horizontal axis represents the temperature for the heat treatment and the vertical axis designates the laser irradiation energy, and A.D. on the horizontal axis is the abbreviation of "As-deposited" and means a PECVD a-Si film immediately after the deposit, i.e., not subjected to any heat treatment. Further, in Fig. 1, character A denotes an amorphous state, character C represents a crystallized state, and character D depicts a damaged state of the film. For example, character A which is present at A.D. on the horizontal axis and at 150 mJ·cm⁻² on the vertical axis indicates a point where the laser irradiation is taken place on a non-heat-treated PECVD a-Si film at an energy density of 150 mJ·cm⁻² and indicates that the film after the laser irradiation is still in an amorphous state. As indicated in this illustration, in the case of the prior PECVD a-Si film, the crystallization does not advance at all in the as-deposited state when the energy intensity is weak (below approximately 160 mJ·cm⁻²), whereas, when energy intensity is high (above approximately 160 mJ·cm⁻²), the film is damaged so as not to function as a semiconductor at all. When the heat treatment is carried out for the PECVD a-Si film, the area crystallized (the region indicated by character C in Fig. 1) expands with the increase in the processing temperature. For instance, in the case of a film to be processed at a temperature of 300°C, the laser energy intensity for the crystallization is only 180 mJ·cm⁻², meanwhile, if the processing temperature is raised to 390°C, the crystallization takes place in a wide crystallizing energy intensity range from 190 mJ·cm⁻² to 310 mJ·cm⁻². Although, in order to make the Si film state clear, in Fig. 1 the area is simply divided into the amorphous area (A), the crystallized area (C) and the damaged area (D), the crystallized area (C) is more finely classified into a well crystallized area, a crystallized area relatively close to the amorphous area, a crystallized area with damage coming on. In Fig. 1, the well crystallized area C is surrounded by a circle. The crystallized film in these areas has a crystallization rate above 70% when the measurement is taken by a wavelength distributed type spectral ellipsometry or a Raman spectroscopic method, which crystallization rate is relatively high. Thus, for the crystallization of the PECVD a-Si film by the laser irradiation method, it is essential that the formed film is heat-treated at a temperature above approximately 400°C. Taking into account the variation of the energy intensity at every laser shot at the time of the laser irradiation, in order to provide a uniform crystallized film with a high quality, the heat treatment temperature is said to be practically above approximately 450°C. In the second prior technique, the maximum process temperature is approximately 450°C being a temperature for the heat treatment of the PECVD a-Si film before the crystallizing process.

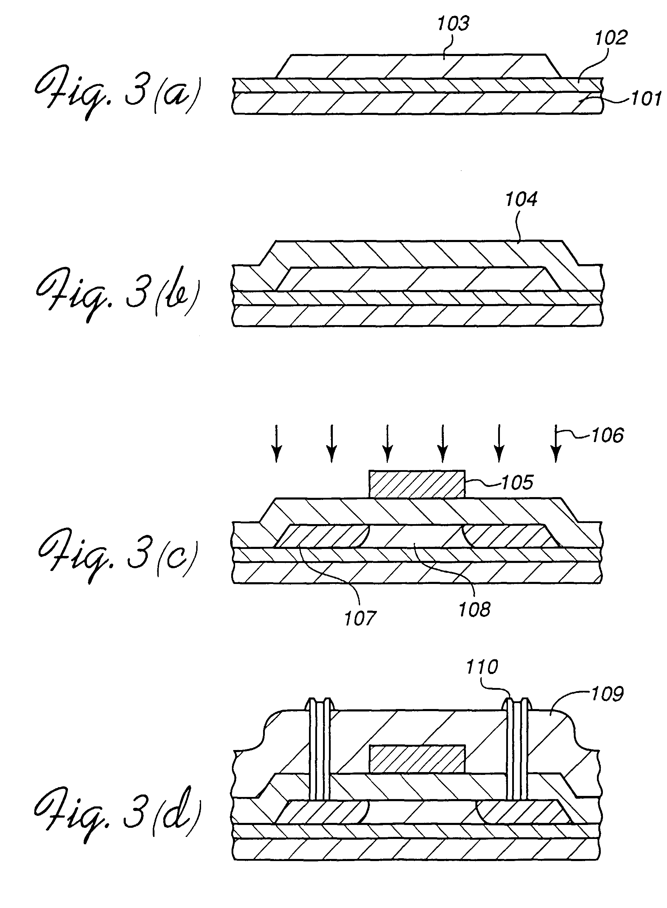

A third prior technique of forming a poly-Si film in the low-temperature process is typically exemplified by the Japanese Published Unexamined Patent Application No. 5-275336. This prior technique involves increasing the laser irradiation energy intensity in succession to allow the crystallization without damage in the laser crystallization of the PECVD a-Si film. In this document, the claim 1 defines that "In a manufacturing method of polycrystallizing a hydrogenation amorphous semiconductor film by laser irradiation, a producing method characterised in that the irradiation energy of laser light is increased gradually to discharge hydrogen in the hydrogenation amorphous semiconductor film stepwise". Moreover, in the same document, the statement of the paragraphs [0022] to [0026] is as follows. That is, according to the paragraph [0022], in a method of applying laser light onto an a-Si : H film, in a state that the laser light output energy is at first set to a value smaller than the energy necessary for the polycrystallization of the a-Si : H film, the scanning irradiation is made several times with a constant energy, for example, 160 mJ (in this case, the beam size is 0.9 cm x 0.9 cm, the transmission factor of the whole optical system is 70%, and hence the energy density on the film surface is 138 mJ/cm².), besides the amount of hydrogen is monitored by a mass spectrometer, and when the hydrogen amount is hardly different from the previous amount at the last scanning, the output energy is slightly increased up to, for example, 200 mJ (the energy density is 173 mJ/cm².), and the scanning irradiation is made several times with the increased energy and the hydrogen amount is similarly monitored. Further, the energy is more increased to, for example, 240 mJ (the energy density is 207 mJ/cm².), then followed by the same processes. In this way, the energy is gradually increased and the same process is effected repeatedly, with the result that the hydrogen in the a-Si : H film is gradually released and, when the laser light is applied to the a-Si : H film with an energy enough to the polycrystallization, the a-Si : H film is changed into a polycrystallized silicon film. In this instance, it is also possible that the laser light irradiation energy (energy per unit area of the surface being processed) is altered by the condensation of the laser beam with no laser light output energy being changed. In addition, the paragraph [0023] notes that Fig. 3 is a diagrammatical illustration of a state of such a laser annealing, where numeral 81 designates a glass substrate (on which a portion of a TFT is placed in the form of a film), numeral 82 denotes an a-Si : H film for producing a TFT at a pixel section, and numeral 83 depicts an a-Si : H film for forming a driver section. Furthermore, according to the paragraph [0024] , according to such an embodiment, a small energy due to laser light is first applied to the a-Si : H film so that the hydrogen amount corresponding to that energy is discharged, and if the scanning irradiation is done several times with the laser light with the same energy, the hydrogen is decreased stepwise corresponding to that energy in accordance with the number of times of the scanning and most of the hydrogen finally goes out. Subsequently, the laser light energy is slightly increased as compared with the previous irradiation energy and the same process is carried out, whereby the hydrogen corresponding to the greater energy generates stepwise in accordance with the number of times of the scanning irradiations and its amount decreases accordingly. Thus, when the laser light irradiation energy increases, the hydrogen successively discharges in correspondence with small energy to large energy. Still further, according to the paragraph [0025], accordingly the hydrogen in the a-Si : H film is discharged stepwise and even the irradiation is transferred to the high energy side in a state with monitoring the amount of the hydrogen, and hence the film is not damaged practically and most of the contained hydrogen is discharged. Thus, when a large energy is applied in order to polycrystallize the a-Si : H film, since the content of the hydrogen in the film is already small, even if the hydrogen is discharged at a stretch, the film does not suffer the damage. On the other hand, if the irradiation is made to the a-Si : H film with an energy sufficient to the polycrystallization of the a-Si : H film, the contained hydrogen is discharged at a time and exploded, which damages the film. Moreover, according to the paragraph [0026], even if in the above process the laser light irradiation energy is set to be large, in the stage that the hydrogen is generated by only below a predetermined amount, as a process the laser light irradiation is carried out with an energy necessary for the polycrystallization of the a-Si : H film for the first time.

However, the methods of forming the poly-Si film in the low-temperature process according to the aforesaid prior techniques suffer from the following problems which are factors of hindering the mass production of a semiconductor device using the poly-Si film, and others.

### Problems on the First Prior Technique

### (Problem 1-1)

Since the process temperature is as high as 550°C, the use of a cheap glass is impossible, which causes increase in the product price. In addition, the distortion of the glass itself due to its dead weight increases in accordance with the increase in its dimension, whereby difficulty is encountered to form a large-area poly-Si film.

### (Problem 1-2)

If the poly-Si film is intended to be applied to a TFT·LCD, the size of the current glass substrate for the LCDs is increasing, shifting from 360 mm x 460 mm to 550 mm x 650 mm, nevertheless an LPCVD apparatus suitable for its size increasing is unavailable.

### Problems on the Second Prior Technique

### (Problem 2-1)

As compared with the LPCVD a-Si, it requires severer aptitude irradiation conditions on the uniform laser irradiation over the whole substrate, and as noted before the adaptive range becomes narrower as the heat treatment temperature is lower. For this reason, the heat treatment temperature needs to be raised from approximately 450°C to approximately 500°C, by which temperature raising the the use of a cheap glass becomes impossible, which causes increase in the product prise. In addition, the distortion of the glass itself due to its dead weight increases in accordance with the increase in its size, whereby the formation of a large-area poly-Si film is difficult. On the other hand, in a case where the heat treatment temperature is as low as less than approximately 450°C, the degree of the crystallization due to the laser irradiation varies, i.e., is constant or irregular, at every lot, which brings the production to be unstable, or the degree of the crystallization is low, that is why difficulty is encountered to provide a high-quality crystalline semiconductor film.

### (Problem 2-2)

The heat treatment is indispensable irrespective of the degree of the heat treatment temperature. Accordingly, in addition to the PECVD apparatus, a heat treatment furnace becomes necessary. Since in general adding of a vacuum apparatus to the heat treatment furnace provides an LPCVD apparatus, the price of the heat treatment furnace is the same degree as that of the LPCVD apparatus. For these reasons, the second prior technique results in being more expensive than the first prior technique. Moreover, the product yield lowers because of a longer process. Furthermore, as well as the problem 1-2, the heat treatment furnace permitting the size of the glass substrate to increase is unavailable.

### Problems on the Third Prior Technique

### (Problem 3-1)

As shown by the aforesaid example, the scanning irradiation is repeated several times at 135 mJ/cm² for removal of hydrogen, and then performed several times at 173 mJ/cm², and further carried out at 207 mJ/cm², that is, the same process is repeatedly done in a state that the irradiation energy successively increases. Thus, the crystallization of the a-Si film takes place after most of the contained hydrogen discharges. Whereupon, the number of times of the laser irradiation must reach at least several tens until the PECVD a-Si film comes into a crystallized condition. For this reason, the productivity significantly lowers and the product price rises. In addition, if the laser irradiation is taken more than several times to the same portion, the careful control of the atmosphere around the substrate is necessary. The laser irradiation in the atmosphere causes the oxygen in the air to taken in the semiconductor film at every laser irradiation. In the case of the removal of hydrogen, the oxygen is caught by the dangling bond after the hydrogen disappears, and in the case of the crystallization, the oxygen is introduced into the film while the Si atoms move. Although a problem does not arises if the number of times of the laser irradiation is several times, in a case where the number of times of repetition of the laser irradiation comes up to ten plus several times, much attention must be paied to the introduction of the oxygen into the film. (Needless to say, the semiconductor characteristic of the ordinary semiconductor material such as Si, Ge and GaAs deteriorates if the oxygen is mixed thereinto.) Accordingly, the third prior technique does not allow the semiconductor film with no introduced oxygen to be obtainable except that the laser irradiation is conducted in a vacuum condition or in non-oxidizing atmosphere. This means that the productivity further lowers and the product price further rises.

### (Problem 3-2)

As noted in the problem 3-1, in this prior technique the energy is increased gradually after the laser irradiation is made in a state that the energy intensity is small. According to such a method of accomplishing the crystallization through the laser irradiation, the crystal particulates are difficult to become large so that the polycrystalline semiconductor film is made up of crystal particulates with relatively small diameters. Accordingly, a high-quality semiconductor film is unobtainable regardless of whether or not the oxygen is introduced thereinto. Thus, the resultant thin-film semiconductor device has an inferior characteristic.

The present invention has been developed in order to eliminate the above-mentioned various problems, and it is therefore an object of the present invention to provide a method of stably and simply manufacturing a high-quality crystalline semiconductor film with a manufacturing apparatus accepting a large-sized glass substrate.

In accordance with a preferred form of the present invention, there is a provided a method of forming a crystalline semiconductor film on an insulating material of a substrate, the substrate at least having the insulating material as a portion of its surface, the method comprising a first step of using a chemical substance containing an element for the semiconductor film as a raw material gas and further using argon (Ar) as an additional gas to deposit the semiconductor film in accordance with a plasma chemical vapor phase deposit (PECVD) method; and a second step of improving a crystallization of the semiconductor film. More specifically, the semiconductor film is a silicon film and a silane (SiH₄, Si₂H₆, Si₃H₈) is used as the raw material gas.

In accordance with another preferred form of this invention, there is provided a method of forming a crystalline semiconductor film on an insulating material of a substrate, the substrate at least having the insulating material as a portion of its surface, the method comprising: a first step of using a chemical substance containing an element for the semiconductor film as a raw material gas and further using an argon (Ar) as an additional gas to deposit the semiconductor film in accordance with a plasma chemical vapor phase deposit (PECVD) method; and a second step of applying one of an optical energy and electromagnetic wave energy to the semiconductor film. In this case, the semiconductor film is a silicon film and a silane (SiH₄, Si₂H₆, Si₃H₈) is used as the raw material gas.

In accordance with a further preferred form of this invention, there is provided a method of forming a silicon film as a crystalline semiconductor film on an insulating material of a substrate, the substrate at least having the insulating material as a portion of its surface, the method comprising: a first step of forming the silicon film in which an absorption peak intensity at the vicinity of 2090 cm⁻¹ is higher than an absorption peak intensity at the vicinity of 2000 cm⁻¹ when measurement of the absorption peak intensity is taken in accordance with an infrared-absorption spectroscopic method; and a second step of improving a crystallization of the silicon film.

In accordance with a further preferred form of this invention, there is provided a method of forming a silicon film as a crystalline semiconductor film on an insulating material of a substrate, the substrate at least having the insulating material as a portion of its surface, the method comprising: a first step of depositing, in accordance with a plasma chemical vapor phase deposit (PECVD) method, the silicon film in which an absorption peak intensity at the vicinity of 2090 cm⁻¹ is higher than an absorption peak intensity at the vicinity of 2000 cm⁻¹ when measurement of the absorption peak intensity is taken in accordance with an infrared-absorption spectroscopic method; and a second step of improving a crystallization of the silicon film.

In accordance with a further preferred form of this invention, there is provided a method of forming a silicon film as a crystalline semiconductor film on an insulating material of a substrate, the substrate at least having the insulating material as a portion of its surface, the method comprising: a first step of forming the silicon film in which an absorption peak intensity at the vicinity of 2090 cm⁻¹ is higher than an absorption peak intensity at the vicinity of 2000 cm⁻¹ when measurement of the absorption peak intensity is taken in accordance with an infrared-absorption spectroscopic method; and a second step of applying one of an optical energy and electromagnetic wave energy to the silicon film.

In accordance with a further preferred form of this invention, there is provided a method of forming a silicon film as a crystalline semiconductor film on an insulating material of a substrate, the substrate at least having the insulating material as a portion of its surface, the method comprising: a first step of depositing, in accordance with a plasma chemical vapor phase deposit (PECVD) method, the silicon film in which an absorption peak intensity at the vicinity of 2090 cm⁻¹ is higher than an absorption peak intensity at the vicinity of 2000 cm⁻¹ when measurement of the absorption peak intensity is taken in accordance with an infrared-absorption spectroscopic method; and a second step of applying one of an optical energy and electromagnetic wave energy to the silicon film.

In accordance with a further preferred form of this invention, there is provided a method of forming a crystalline semiconductor film on an insulating material of a substrate, the substrate at least having the insulating material as a portion of its surface, the method comprising: a first step of depositing the semiconductor film which has a pillar-like configuration; and a second step of improving a crystallization of the pillar-like semiconductor film. In this instance, the semiconductor film is a silicon film.

In accordance with a further preferred form of this invention, there is provided a method of forming a crystalline semiconductor film on an insulating material of a substrate, the substrate at least having the insulating material as a portion of its surface, the method comprising: a first step of depositing the semiconductor film which has a pillar-like configuration; and a second step of applying one of an optical energy and electromagnetic wave energy to the pillar-like semiconductor film. In this instance, the semiconductor film is a silicon film.

In accordance with a further preferred form of this invention, there is provided a method of forming a crystalline semiconductor film on an insulating material of a substrate, the substrate at least having the insulating material as a portion of its surface, the method comprising: a first step of depositing the semiconductor film, which has a pillar-like configuration, in accordance with a plasma chemical vapor phase deposit (PECVD) method; and a second step of improving a crystallization of the pillar-like semiconductor film. The semiconductor film is a silicon film.

In accordance with a further preferred form of this invention, there is provided a method of forming a crystalline semiconductor film on an insulating material of a substrate, the substrate at least having the insulating material as a portion of its surface, the method comprising: a first step of depositing the semiconductor film, which has a pillar-like configuration, in accordance with a plasma chemical vapor phase deposit (PECVD) method; and a second step of applying one of an optical energy and electromagnetic wave energy to the pillar-like semiconductor film. The semiconductor film is a silicon film.

The present invention will be further described with reference to the accompanying drawings in which:
Fig. 1 is a graphic view showing a laser crystallization characteristic of a prior PECVD a-Si film;
Fig. 2 illustrates an arrangement of a PECVD apparatus used for this invention;
Fig. 3 showing processes (a) to (d) of manufacturing a thin-film semiconductor device according to an embodiment of this invention;
Fig. 4 is a graphic view showing an infrared absorption spectrum of a semiconductor film according to this invention;
Fig. 5 is a graphic view showing an infrared absorption spectrum of a prior a-Si film;
Fig. 6 is a graphic view showing a Raman spectroscopic spectrum of a prior a-Si film;
Fig. 7 is a graphic view showing a Raman spectroscopic spectrum of a semiconductor film according to this invention;
Fig. 8 is a graphic view showing a laser crystallization characteristic of a semiconductor film according to this invention;
Fig. 9 is a graphic view showing an infrared absorption spectrum of a semiconductor film according to this invention;
Fig. 10 is a graphic view showing a Raman spectroscopic spectrum of a semiconductor film according to this invention; and
Fig. 11 is a graphic view showing a laser crystallization characteristic of a semiconductor film according to this invention.

Referring now to the drawings, a description will be made hereinbelow of a basic principle and embodiments of the present invention.

### (1. Substrate and Surface Protective Film to which the Invention is Applicable)

First of all, a description will be taken of a substrate and a surface protective film to which this invention is applicable. Among substrates to which this invention is applicable are conductive materials such as a metal, ceramic materials such as a silicon carbide (SiC), an alumina (Al₂O₃) and an aluminium nitride (AlN), transparent insulating materials such as a molten quartz and a glass, semiconductor substrates such as a silicon wafer, LSIs obtainable by processing the aforesaid semiconductor substrates, and crystalline insulating materials such as a sapphire (trigonal system Al₂O₃ crystal). As general glass substrates usable, there are the #7059 glass or 1737 glass manufactured by Coning Japan Co., Ltd., the OA-2 glass manufactured by Nippon Denki Garasu Co., Ltd., and the NA35 glass manufactured by NH Technoglass Co., Ltd., and others. Irrespective of the kind of the substrate, the semiconductor film is deposited on an insulating material made as at least a portion of the surface of a substrate. In this application, this insulating material is referred to as a surface protective film. For example, in a case where a molten quartz substrate is used as the substrate, since the substrate itself constitutes an insulating material, the semiconductor film can directly be deposited on the molten quarts substrate. Further, it is also possible that an insulating material such as a silicon oxide film (SiOx : 0 < x ≤ 2) and silicon nitride film (Si₃Nx : 0 < x ≤ 4) is formed as a surface protective film on a molten quartz substrate and a semiconductor film is further formed thereon. If the ordinary glass is used for the substrate, the semiconductor film may directly be deposited on the ordinary glass being an insulating material, whereas in this case it is preferable that a surface protective film is formed on the glass substrate using an insulating material such as a silicon oxide film and a silicon nitride film before the semiconductor film is deposited thereon so that moving ions such as natrium (Na) contained in the glass are not mixed into the semiconductor film. Thus, when the semiconductor film according to this invention is applied to a thin-film semiconductor device, the operational property does not vary regardless of the long use and the use under a high voltage, and hence stability improves. Except for the case that a crystalline insulating material such as a sapphire is used for the substrate, it is preferable that the semiconductor film is deposited on the surface protective film. In a case where various kinds of ceramics are employed as the substrate, the surface protective film plays a role of preventing a sintering assistant raw material added into a ceramic from being dispersed and mixed into the semiconductor section. Further, if a metallic material is employed for the substrate, the surface protective film is indispensable because of ensuring its insulation. Moreover, in the case of a semiconductor substrate or an LSI element, an interlayer insulating film or the like between transistors or between wirings serves as the surface protective film. The dimension and configuration of the substrate are freely selectable except that the dimension and configuration do not give rise to deformation such as expansion and contraction and distortion. That is, the selection is possible in a range from a disc with a diameter of approximately 3 inches (76.2 mm) to a rectangular substrate with a dimension of approximately over 560 mm x 720 mm.

After a substrate is first cleaned using pure water, the surface protective film is formed on that substrate with an oxide film such as a silicon oxide film, an aluminium oxide film and a tantalum oxide film or a nitride film such as a silicon nitride film according to such a CVD method as an APCVD method and an LPCVD method or such a PVD method as a sputtering method. In the case of the APCVD method, a silicon oxide film can be deposited at a substrate temperature of approximately 250°C to 450°C if using as the raw materials a monosilane (SiH₄) and oxygen. On the other hand, in the case of the PECVD method or the sputtering method, the surface protective film is producible at a substrate temperature from the room temperature to 400°C. The surface protective film is required to have a thickness sufficient to avoid the dispersion and mixing of impurity ions from the substrate side, and needs to be at least approximately 100 nm. If taking the variation between the lots and between the substrates into consideration, preferably the thickness is above approximately 200 nm. If being 300 nm, the surface protective film can satisfactorily function as a film for protection. When the surface protective film also serves as a interlayer insulating film between IC elements or between the wirings or the like for connections therebetween, the film thickness is commonly taken to be approximately 400 nm to 600 nm.

### (2. Raw Material for Formation of Semiconductor Film according to the Invention)

In this invention, a semiconductor film is deposited on some substrate. This is taken in all the following embodiments of this invention. As the kind of a semiconductor film to which this invention is applicable, in addition to a single semiconductor film such as silicon (Si) and germanium (Ge) there are semiconductor films made of tetragroup element complex materials such as a silicon germanium (SiₓGe₁₋ₓ : 0 < x < 1), a silicon carbide (SiₓC₁₋ₓ : 0 < x < 1) and a germanium carbide (GeₓC₁₋ₓ : 0 < x < 1), semiconductor films made of trigroup element and pentagroup element complex compounds such as a gallium arsenic (GaAs) and an indium antimony (InSb), semiconductor films made of digroup element and hexagroup element complex compound materials such as a cadmium selenium (CdSe). Or, this invention is also applicable to semiconductor films made of complex compounds such as a silicon germanium gallium arsenic (SiₓGe_{y}Ga_{z}As_{z} : x + y + z = 1) and N-type semiconductor films produced by adding donor elements such as phosphorus (P), arsenic (As) and antimony to these semiconductor films, and P-type semiconductor films produced by adding acceptor elements such as boron (B), aluminium (Al), gallium (Ga) and indium (In) thereto.

In this invention, when the deposit is made according to the CVD method, a chemical substance containing elements constituting the semiconductor film being deposited acts as a raw material gas to deposit the semiconductor film. For example, if the semiconductor film is made of silicon (Si), as the raw material gas there is used a silane such as a monosilane (SiH4), a disilane (Si₂H₆), a trisilane (Si₃H₆), and a dichlorosilane (SiH₂Cl₂). In this specification, the disilane or trisilane is referred to as a high-order silane (SiₙH₂ₙ₊₂ : n is an integer which is 2 or more). In the case of the semiconductor film being made of germanium (Ge), a germane (GeH₄) or the like is put in use. When phosphorus (P) or boron (B) is added into the semiconductor film, a phosphine (PH₃), a diboron (B₂H₆) or the like is used together. Although as the raw material gas there is used a chemical substance containing the elements making up aforesaid various semiconductor films, since a portion of the raw material gas always remains in the semiconductor film, the hydride of the constituting element is more preferable. For example, chlorine (Cl) always remains irrespective of the degree of the amount in a silicon film made of a dichlorosilane (SiH₂Cl₂), and in the case of applying this silicon film to an active layer of a thin-film semiconductor device, the remaining chlorine can deteriorate the transistor characteristics. Accordingly, a monosilane (SiH4) being a hydrogen compound of the constituting element is more preferable than the dichlorosilane. It is more preferable as the purity of the raw material gas and the additional gas added if required is higher, while taking into account the more technical difficulty in attaining the high-purity gas and the raise of the price, the purity is preferable to be above 99.9999%. In general, the semiconductor film forming apparatus has a background vacuum degree of approximately 10⁻⁶ torr, and has a film forming pressure of 0.1 torr to several torr. Whereupon, the rate of introduction of the impurities from the background vacuum to film forming processes is about 10⁻⁵ to 10⁻⁶. The purity of the raw material gas or the additional gas to be used for the film formation is sufficient if being equal to the ratio of the film forming pressure to the background vacuum degree of the film forming apparatus utilizing that gas. Accordingly, in this invention, the purity of the gas flowing into the film forming apparatus is preferable to be above 99.999% (the rate of the purity is below 1 x 10⁻⁵), and if the purity is 99.9999% (the rate of the purity is below 1 x 10⁻⁶), this raw material has no problem at all. Further, if the purity is ten times the ratio of the background vacuum degree to the film forming pressure (in this instance, the purity is 99.99999% and the rate of the impurities is below 1 x 10⁻⁷), there is no need for the introduction of the impurities to be taken into consideration, and it gets into an ideal condition.

### (3. PECVD Apparatus Used in this Invention)

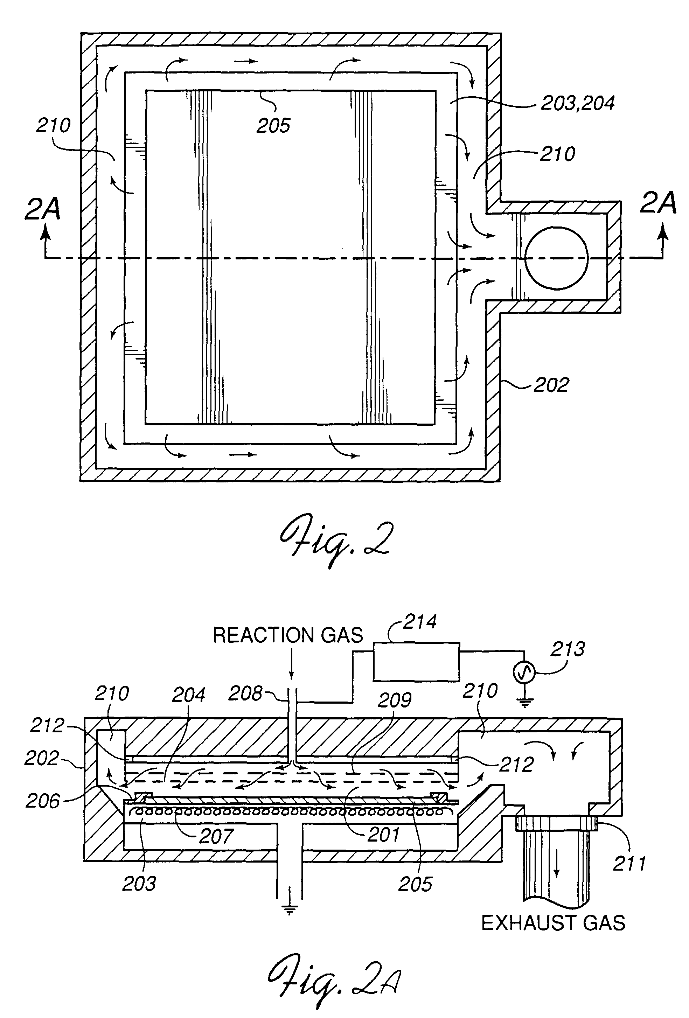

With reference to Fig. 2 a description will be made hereinbelow of the outline of an arrangement of a plasma chemical vapor phase depositing apparatus (PECVD apparatus) employed in this invention. The PECVD apparatus is of the capacitive coupling type, and the plasma is designed to take place between parallel flat-plate-like electrodes by means of a high-frequency power source with an industrial frequency (13.56 MHz). The upper side view of Fig. 2 schematically shows a reaction chamber and others viewed from the above, where the lower side view of Fig. 2 is a cross section taken along line A-A' in the upper side view of Fig. 3. A reaction chamber 201 is isolated from the outside atmosphere by means of a reaction container 202, and comes into a pressure-reduced condition of approximately 0.1 torr to 10 torr during the film formation. Within the reaction container 202 there are placed a lower flat-plate-like electrode 203 and an upper flat-plate-like electrode 204 disposed in opposed relation to each other. These two electrodes constitute parallel flat plate electrodes. The reaction chamber 201 is defined between the parallel flat plate electrodes. According to this invention, the parallel flat plate electrodes have a dimension of 470 mm x 560 mm, and the distance therebetween is changeable between 18.0 mm to 37.0 mm and, hence, the volume of the reaction chamber 201 varies from 4738 cm³ to 9738 cm³ in accordance with the distance between the electrodes. The distance between the parallel flat plate electrodes can freely be set to between 10.0 mm and 40.0 mm in such a way that the position of the lower flat plate electrode 203 is shifted up and down. In a case where the distance therebetween is set to a given value, the deviation of the interelectrode distance within the flat plate electrode surface of 470 mm x 560 mm is only 0.5 mm. Accordingly, the deviation of the electric filed strength established between the electrodes becomes below approximately 2% within the flat plate electrode surface, with the result that the plasma with an extremely uniform quality generates within the reaction chamber 201. On the lower flat plate electrode 203 there is located a substrate 205 on which the thin-film is deposited and the circumferential portion of which is pressed by 2 mm through a shadow frame 206. In the upper side view of the Fig. 2, the shadow frame 206 is omitted in order to make the outline of the PECVD apparatus clear. In the inside of the lower flat plate electrode 203 there is provided a heater 207 which allows the temperature of the lower flat plate electrode 203 to be adjustable between 250°C and 400°C. The temperature distribution in the lower flat plate electrode 203 other than the circumferential section (2 mm width) is within ± 5°C with respect to the set temperature, and hence, even if the size of the substrate 205 is substantially set to 360 mm x 465 mm, the temperature deviation within the substrate 205 is maintainable within ± 2°C. For example, when a general glass substrate (for instance, #7059 manufactured by Coning Japan Co., Ltd., OA-2 manufactured by Nippon Denki Garasu Co., Lit., NA35 manufactured by NH technoglass Co., Ltd., and so on) is used as the substrate 205, the shadow frame 206 prevents the substrate to be curvedly deformed due to the heat from the heater 207 concurrent with pressing the substrate so that unnecessary thin-film is not formed on the edge portions of the substrate and the rear surface thereof. A reaction gas comprising the raw material gas and the additional gas is led through a pipe 208 into the upper flat plate electrode 204, and passes into a gas dispersion plate 209 to flow from the whole upper flat plate electrode surface into the reaction chamber 201 under a substantially even pressure. If during the film formation process, a portion of the reaction gas is electrolytic-dissociated when being out of the upper flat plate electrode so that the plasma occurs between the parallel flat plate electrodes. A portion of or all the reaction gas contributes to the film formation, and the remaining reaction gas which does not contribute to the film formation and the gas produced by the chemical reaction for the film formation are discharged as an exhaust gas through an exhaust hole 210 made in a circumferential and upper portion of the reaction container 202. The conductance of the exhaust hole 210 is sufficiently greater than the conductance between the parallel flat plate electrodes and is preferable to be more than 100 times the conductance between the parallel flat plate electrodes. Further, the conductance between the parallel flat plate electrodes is sufficiently larger than the conductance of the gas dispersion plate 209 and is also preferable to be more than 100 times the conductance of the gas dispersion plate 209. With such a construction, the reaction gas is led into the reaction chamber 201 from the whole surface of the large-sized upper flat plate electrode of 470 mm x 560 mm under a substantially uniform pressure, and at the same time the exhaust gas is discharged from the reaction chamber 201 in all the directions with an even flow rate. The flow rate of the various reaction gases is adjusted to a given value by a mass flow controller before the gases are led into the pipe 208. Furthermore, the pressure within the reaction chamber 201 is adjusted to a desired value by a conductance valve 211 placed at the exit of the exhaust hole 210. At the exhaust side of the conductance valve 211 there is provided a vacuum exhaust unit such as a turbo-molecular pump. In this invention, an oil-free dry pump is used as a portion of the vacuum exhaust pump and the background vacuum degree within the reaction container 202 including the reaction chamber 201 is on the order of 10⁻⁵ torr. In Fig. 2, the arrows schematically indicate the flow of the gas. The reaction container 202 and the lower flat plate electrode 203 has the grounded potential and are maintained to be electrically insulated from the upper flat plate electrode 204 through an insulating ring 212. At generation of the plasma, a high-frequency wave of, for example, 13.56 MHz outputted from a high-frequency wave oscillation source 213 is applied through an impedance matching circuit 214 to the upper flat plate electrode 204.

The PECVD apparatus used in this invention, as described above, can realize an extremely precise interelectrode control and uniform gas flow and hence acts as a thin-film forming apparatus which is capable of dealing with a large-sized substrate of 360 mm x 465 mm. In addition, these basic concepts can also realize an apparatus which can easily deal with a larger-sized substrate having, for example, a dimension of 550 mm x 650 mm. In addition, although in this invention a high-frequency wave with a frequency of 13.56 MHz that shows the widest application is used, it is also appropriate to use a high-frequency wave having a frequency integral times that frequency. For example, doubled 27.12 MHz, tripled 40.68 MHz, quadrupled 54.24 MHz and others are also effective. Moreover, it is also possible to use a VHF wave of approximately 100 MHz to 1GHz. If using in the range from an RF wave having a frequency of an approximately 10 MHz to a VHF wave having a frequency of approximately several hundreds MHz, the plasma can take place between the parallel flat plate electrodes. Thus, in the PECVD apparatus used for this invention, if the high-frequency wave oscillation source 213 and the impedance matching circuit 214 are replaced with different ones, the generation of the plasma is possible using a high-frequency wave with a desired frequency. In the case of a general high-frequency plasma, the electron temperature of the plasma increases with the increase in the frequency so that the radical generation becomes easy. For this reason, the high-frequency plasma is particularly effective to a thin-film forming method according to this invention which will be described later.

### (4. Semiconductor Film according to this Invention and Deposit by PECVD Method)

A description will be made hereinbelow of a first semiconductor film for formation of a crystalline semiconductor according to this invention and a method of forming it in accordance with the PECVD technique. After a surface protective film being an insulating material such as a silicon oxide film is provided in at least a portion of the surface of a substrate, the first semiconductor film is formed on the surface protective film and finally the crystallization of the semiconductor film is accomplished.

The substrate is placed within the PECVD apparatus where the lower flat plate electrode 203 is kept to have a temperature of 380°C. The PECVD apparatus is set to be the same as the film forming process except for the generation of the plasma. For example, 50 SCCM of monosilane and 3000 SCCM of argon are made to flow, and the pressure within the reaction chamber 201 is maintained to be 1.5 torr. The distance between the parallel flat plate electrodes is 24.4 mm. After the substrate installed becomes in equilibrium condition with such a system, the substrate surface temperature is 349°C. If the time taken until the equilibrium condition is made after the substrate is located within the PECVD apparatus is referred to as equilibrium time, in the case of the substrate whose temperature is kept to the room temperature, the equilibrium time assumes at least 5 to 6 minutes. This equilibrium time depends upon the thickness of the substrate, the heat capacity, the thermal conductivity, the substrate temperature before the installation, the kind of the gas introduced into the reaction chamber 201, the flow rate of the introduced gas, the gas pressure and so on. For example, if the thickness of the substrate becomes thinner from 1.1 mm taken in this invention to 0.7 mm, the equilibrium time is also reduced to 3 to 4 minutes in substantial proportion to the thickness of the substrate. If preheating is performed before the substrate is installed within the reaction chamber 201, the equilibrium time is also reducible. Particularly, if the preheating is effected at a temperature higher by approximately 10°C than the substrate surface temperature in the equilibrium condition, it is possible that the equilibrium time is reduced to about 1 minute. The reduction of the equilibrium time results in the improvement of the throughput and the reduction of the product price.

After the equilibrium condition, a high-frequency wave is given to the upper flat plate electrode 204 to generate the plasma for the formation of the film. For example, the high-frequency wave output is 600W. That is, one example of the silicon film deposit condition is as follows.
silane flow rate : SiH₄ = 50 SCCM
argon flow rate : Ar = 3000 SCCM
   (raw material concentration 1.64%)
high-frequency wave output : RF = 600W (0.22 W/cm²)
pressure : P = 1.5 Torr
distance between electrodes : S = 24.4 mm
lower flat plate electrode temperature : Tsus = 380°C
substrate surface temperature : Tsub = 349°C

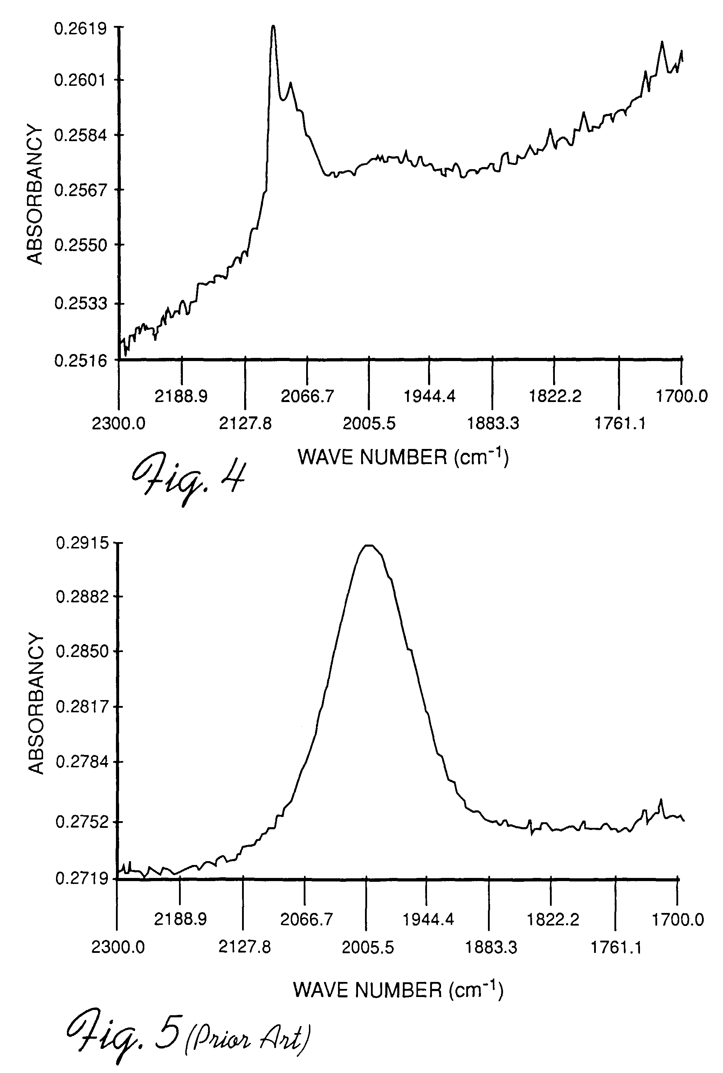

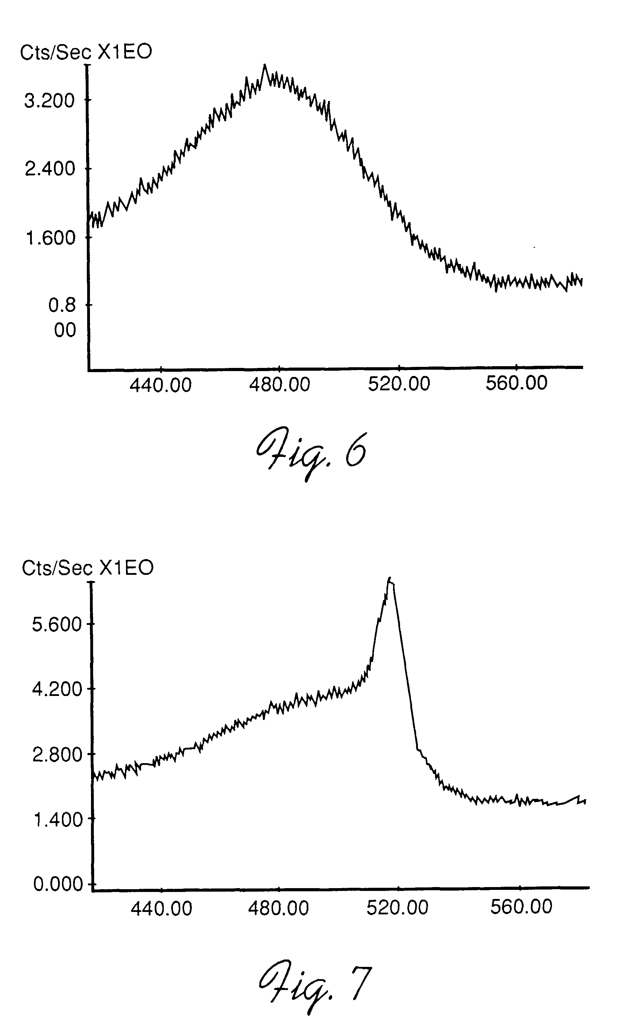

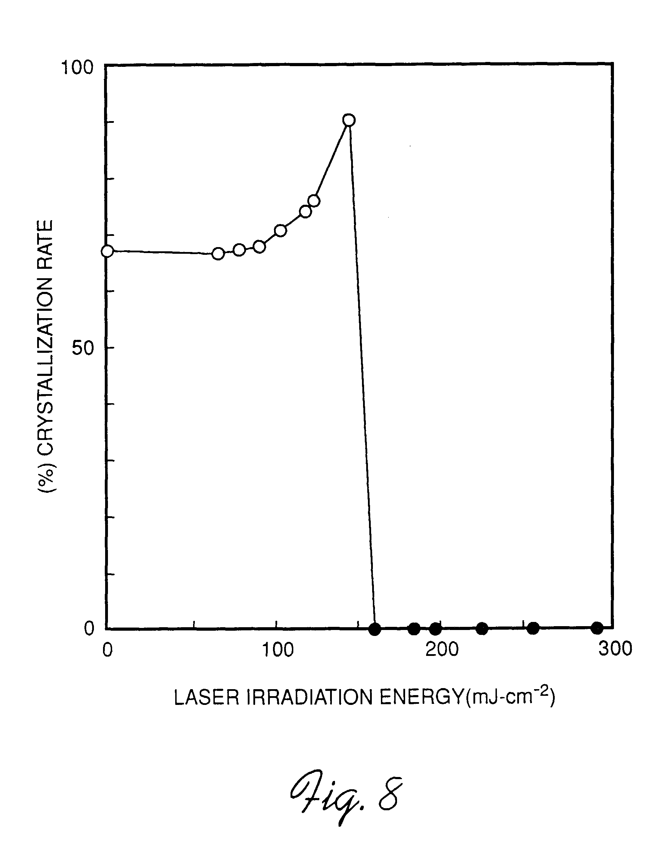

Under these conditions, the deposit speed of the semiconductor film becomes 0.327 nm/s, and the hydrogen concentration in the silicon film is 9.10 atom % when being measured by a heat desorption gas spectroscopy (TDS). In addition, according to the observation by a transmission type electron microscope, this silicon film has a pillar-like configuration. Fig. 4 shows a spectrum of the silicon film measured by the infrared absorption spectroscopic method. When being compared with a prior a-Si film (Fig. 5), it is found that the absorption peak intensity at the vicinity of 2090 cm⁻¹ is larger than the absorption peak intensity at the vicinity of 2000 cm⁻¹. On the other hand, Fig. 7 shows a measurement result of the silicon film taken by the Raman spectroscopic method. According to this illustration, a peak appears at the vicinity of 520 cm⁻¹, which peak is not found on the silicon film by the prior technique as shown in Fig. 6. This is a Raman shift from the crystal component contained in the silicon film. That is, the silicon film obtained according to this invention shows a mixed crystal including an amorphous and a crystalline. In consequence, the silane being a chemical substance containing a silicon which is an element for making the semiconductor film is used as the raw material gas, and argon is used as the additional gas. The resultant silicon film deposited by the PECVD method is of a mixed crystal having a pillar-like configuration. In addition, in this semiconductor film, hydrogen of approximately 1% to 10% is contained in a state with being coupled to the amorphous silicon or crystalline silicon. The IR peaks thereof are mainly present in the vicinity of 2090 cm⁻¹. For simplicity, this semiconductor film will hereinafter be referred to as (Ar-based) mixed crystal film.

The important parameters for depositing such a (Ar-based) mixed crystal semiconductor film by the PECVD method are four: the kind of the additional gas, the pressure, the distance between the electrodes and the substrate surface temperature. Secondly, a detailed description will be made in terms of these things.

One of the features of this invention is to obtain the as-deposited film as a mixed crystal with a relatively high crystalline according to the PECVD method which is used for general purposes. In general, extreme difficulty is encountered to create a mixed crystal with a high crystalline from the as-deposited film according to the PECVD method. The reason is that, because the substrate temperature is low as below approximately 400°C, the mobility lowers at the growing film surface of the raw material such as silane and the selectivity to the crystal state of the raw material with respect to the amorphous (noncrystal) state is lost. This invention can resolve this disadvantage of the PECVD method by introducing the additional gas such as argon (Ar) and further by diluting the raw material with the additional gas. For the formation of a mixed crystal with a high crystalline in the as-deposited condition, the radical or ion of the raw material is not made but the radical or ion of argon (Ar) is made, and the energy needs to be carried by these to the substrate surface. The radical or ion of the raw material causes a gas phase reaction or reacts immediately when the raw material reaches the substrate surface so that the selectivity is lost to hinder the crystal growing in the semiconductor film surface. Accordingly, the formation thereof in the plasma of the radical or ion is necessary to possibly avoid. The raw material is carried to the growing film surface in an inert state, and after absorbed thereat, the energy for the reaction is supplied through the dilute gas or the like so that a mixed crystal film with a high crystalline is formed in the as-deposited state. Thus, the dilution of the raw material gas is necessary, and further it is required that a gas for promoting the reaction of the raw material on the substrate surface is carried as a diluting substance. Since argon consists of elemental atoms, the spectrum of the ionization potential is extremely simple. The univalent ionization potential of argon is 15.759 eV, the bivalent ionization potential is 27.629 eV, and the trivalent ionization potential is 40.74 eV. Whereupon, in a case where a small amount of raw material is diluted in the argon to generate the plasma, the ionized argon mainly assumes both univalent ions and bivalent ions, and the ionization energy is relatively low so that the radical or ion of the argon is produced effectively. Going the other way, in the case of hydrogen which has heretofore been put in widespread use, the ionization potential of the hydrogen molecular takes ten and several different values between 15 eV and 18 eV. For this reason, although the argon creates a plasma state with one or two energies (for example, laser light), the molecular gas such as hydrogen produces a plasma state including a number of energies (white light). The laser light can more effectively carry the energy as compared with the white light, and if the raw material gas is diluted with the argon with a low ionization energy, the energy can be carried more effectively to the substrate surface. As the diluting material at deposit of the semiconductor film, in addition to the argon there may be used noble gas elements such as helium (He), neon (Ne), krypton (kr) and xenon (Xe).

The essential condition or requirement on the pressure is to be 1.0 Torr. Even if the other parameter is close to the essential condition value (likely to be out of the essential condition), the (Ar-based) mixed crystal film can surely be formed if the pressure is above approximately 1.6 Torr. If the pressure becomes excessive, the plasma is unstable so that abnormal discharge takes place. In this invention, in order to stably produce uniform plasma, the pressure is preferable to be approximately 2.7 Torr. The essential requirement on the distance between the electrodes is that the interelectrode distance is above approximately 17.8 mm. Even if the other parameter is close to the essential condition value (likely to be out of the essential condition), the (Ar-based) mixed crystal film can surely be formed if the interelectrode distance is above approximately 25.4 mm. If the interelectrode distance is excessively large, the plasma also becomes unstable so that the abnormal discharge takes place. In this invention, in order to stably produce uniform plasma, the interelectrode distance is below approximately 45.7 mm. The essential requirement on the substrate surface temperature does not exist, while the formation of the mixed crystal film is relatively easy if the temperature is above approximately 200°C. If considering that a low-price large-sized glass substrate is handled with no trouble, it is desired that the temperature is below approximately 400°C.

The (Ar-based) mixed crystal film prefers a higher pressure and further prefers a larger interelectrode distance. However, bringing these parameters to desired values results in lowering the film formation speed. From a practical point of view in manufacturing, the lower limit of the desired film formation speed is approximately 0.3 nm/s.

### (5. Crystallization of Semiconductor Film according to this invention and Melt crystallization)

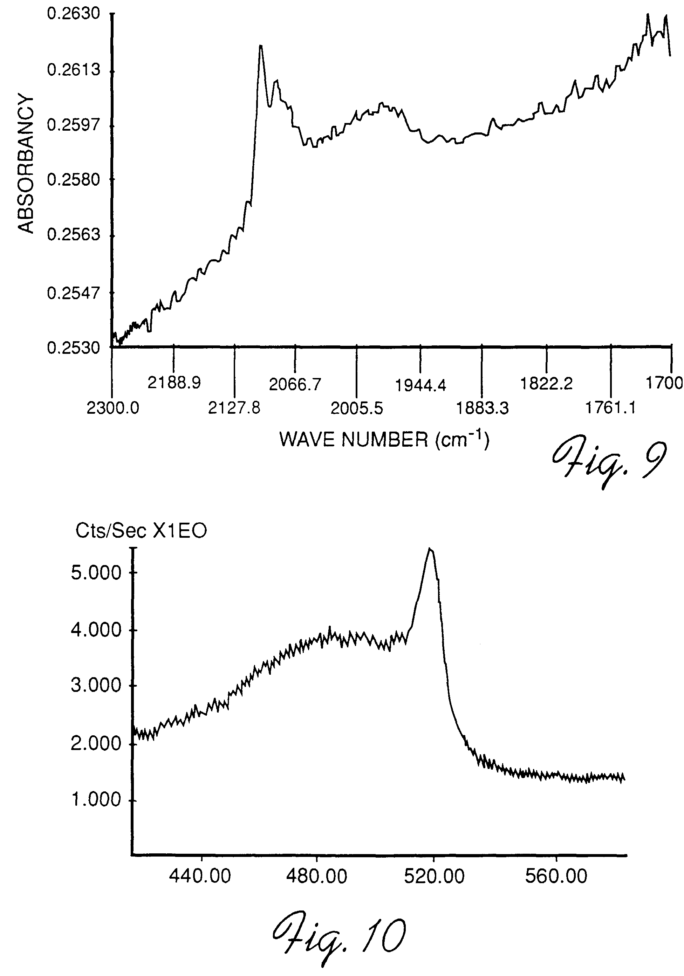

It was found that, when the crystallization of the semiconductor film according to this invention described in the chapter (4) is effected with laser irradiation, the crystallization is possible by the melt crystallizing method or the SPC method with no heat treatment being done before the crystallization process. This state will be described with reference to Fig. 8. Fig. 8 shows the variation of the crystalline due to the laser irradiation to a (Ar-based) mixed crystal as-deposited film. That is, the (Ar-based) mixed crystal film is formed to have a thickness of 50 nm under the following requirements.
silane flow rate : SiH₄ = 50 SCCM
argon flow rate : Ar = 3000 SCCM
   (raw material concentration 1.34%)
high-frequency wave output : RF = 600W (0.228 W/cm²)
pressure : P = 1.5 Torr
distance between electrodes : S = 24.4 mm
lower flat plate electrode temperature : Tsus = 380°C
substrate surface temperature : Tsub = 349°C

An XeCl excimer laser light having a wavelength of 308 nm was directly applied to this film without any heat treatment (the as-deposited state) and examination was conducted of the variation of the crystalline. The half band width of the excimer laser is approximately 45 ns, and the irradiation was made to an about 1 cm x 1 cm rectangular configuration once with each energy. In Fig. 8 the horizontal axis designates the energy density on the substrate surface at each irradiation and the vertical axis denotes the crystallization rate of the semiconductor film after the laser irradiation. The crystallization was measured by a multiwavelength distributed type ellipsometry. In addition, in the illustration, the black circles indicate that the result of the laser irradiation shows a damaged semiconductor film, corresponding to D in Fig. 1. In the case of the ellipsometry measurement, when the crystallization rate exceeds approximately 70%, it is taken as a polycrystallization state, and hence a crystallization clearly advances when the laser energy density is between approximately 100 mJ·cm⁻² and approximately 150 mJ·cm⁻². In Fig. 8, when the energy density is 145 mJ·cm⁻², the crystallization rate comes up to the maximum 92% so that a high-quality semiconductor film is obtainable. As shown by this example, if using the (Ar-based) mixed crystal semiconductor film according to this invention, a high-quantity semiconductor film having a high crystallization rate is easily producible with a simple laser irradiation but with no heat treatment which have been conducted heretofore for the removal of hydrogen.

If a poly-Si film is produced according to such a manufacturing method, a poly-Si TFT is producible in accordance with a common manufacturing method for the thin-film semiconductor device afterwards. Owing to the high crystalline the melt crystallized film has, it is also possible to produce a high-quality thin-film semiconductor device where the mobility is about 100 cm²·V⁻¹·S⁻¹.

In the semiconductor film according to this invention which has been described in the chapter (4), a slight crystal structure was found when being measured by the Raman spectroscopic measurement and others. However, this is not a polycrystal. In addition, the density is low, that is, the same as that of the amorphous silicon formed according to the prior PECVD method, and the hydrogen atom is contained by about 20% of the silicon atom. Although the reason why such a film gets into a clear melt crystallization is not known in detail, it is considered as follows. That is, perhaps the amorphous region is more easily molten than the microcrystal region and the microcrystal floating in the molten silicon liquid plays a role of a paste which can suppress the evaporation and fly of the molten silicon solution and further plays a role of a crystal growing core in the cooling cured process. For these reasons, the laser energy density for the melt crystallization of the (Ar-based) mixed crystal semiconductor film is lowered by approximately 50 mJ·cm⁻² as compared with the prior art. This means that, in a case where the melt crystallization of the semiconductor film is effected with the same laser output using the same laser irradiation equipment, the (Ar-based) mixed crystal film according to this invention has a wider area crystallized due to one laser irradiation, as compared with the prior amorphous film. That is, the (Ar-based) mixed crystal film further reduces the load on the laser irradiation equipment and improves the productivity.

As described in detail in the chapter (4), under a special film formation condition, the general purpose PECVD method can provide a mixed crystal film with a high crystalline even in the as-deposited state. However, that film has no more excellent quality than that of the crystallized film. On the other hand, the film attained by the ordinary PECVD method encounters difficulty in the crystallization except for the case of performing the heat treatment for the removal of hydrogen and the fining. On the other hand, the crystallization or melt crystallization of the mixed crystal semiconductor film with a high crystalline is easily possible by the RTA method, the VST-SPC method, or the laser irradiation. This may be because most of the film is crystallized in the as-deposited state and the remaining amorphous component is little and hence the remaining amorphous component can be crystallized with the supply of a relatively small energy. In addition, also in a case where the melt crystallization is accomplished with a large energy, the polycrystallized component serves as a paste to prevent the evaporation and fly of the semiconductor atom and hence the crystallization is possible without the damage, roughness and loss of the semiconductor film. In consequence, the mixed crystal semiconductor film according to this invention is most suitable as the first semiconductor film in forming a crystalline semiconductor film using the melt crystallization. That is, the mixed crystal semiconductor film with a high crystalline is form on an insulating material according to the PECVD method or the like, and then this film is crystallized by the solid phase crystallizing method such as the RTA method and the VST-SPC method or the melt crystallization (SPC) method such as the laser irradiation, with the result that a high-quality crystalline semiconductor film is readily formable.

The (Ar-based) mixed crystal semiconductor film according to this invention is obtainable by the PECVD method using a chemical substance containing an element of the inert gas such as argon and an element such as a monosilane for making a semiconductor film. In general, the mixed crystal silicon film is also formable if the monosilane is diluted to approximately 3% with hydrogen. However, according to the test by the applicant, hydrogen-monosilane-based mixed crystal has an extreme difficulty in the melt crystallization if the heat treatment is not made. The crystallization is Occasionally possible without the heat treatment, whereas the reproductivity is extremely low and the laser energy range where the melt crystallization is successful is limited to at most below approximately 10 mJ/cm². On the other hand, the argon-monosilane-based mixed crystal silicon film can be crystallized over a wide energy range from above approximately 50 mJ/cm² to approximately 350 mJ/cm² if the thickness of the semiconductor film and film formation condition are subjected to adjustments. Accordingly, the hydrogen-based mixed crystal semiconductor film is also suitable as an initial semiconductor film for forming a crystalline semiconductor film, while the (Ar-based) mixed crystal semiconductor film described in detail in the chapter (4) is more suitable.

Secondly, a description will be made hereinbelow of a method of obtaining a crystalline semiconductor film by the crystallization of the semiconductor film. The irradiation method will be described in the case of using an example of a xenon chloride (XeCl) excimer laser (wavelength : 308 nm). The intensity half band width of the laser pulse is 45 ns. Since the irradiation time is extremely short, in the crystallization of as a semiconductor film of, for example, a mixed crystal, the substrate is not heated, with the result that the deformation of the substrate and others do not occur. The laser irradiation brings the substrate to be between the room temperature (25°C) and 400°C, and is performed in the air or in a vacuum atmosphere. The area receiving one laser irradiation has a square configuration of 8 mm, and the position to be irradiated is shifted by 4 mm at every irradiation. After the scanning is first made in the horizontal direction (Y direction), the position to be irradiated is also shifted by 4 mm in the vertical direction (X direction) and again shifted by 4 mm in the horizontal direction before the scanning is done. Thereafter, this scanning is repeatedly carried out so that the first laser irradiation is completed over whole substrate surface. The first laser irradiation energy density is preferable to be approximately 80 mJ/cm² to 250 mJ/cm². After the completion of the first laser irradiation, the energy density is set to be higher than that of the first laser irradiation and the second laser irradiation is conducted over the whole substrate surface. The second laser irradiation energy density is preferable to be between 100 mJ/cm² to 600 mJ/cm². The scanning method is the same as that for the first laser irradiation, and the area to be irradiated has a square configuration of 8 mm and is shifted by 4 mm in the X and Y directions. If using this two-stage laser irradiation method, it is possible to perfectly eliminate the variations of the laser beam at edge portions. In the first and irradiations of the two-stage laser irradiation, the irradiation is effected with an energy density which can not damage the semiconductor film. Furthermore, it is also possible to use the one-stage laser irradiation method using a laser beam with a large energy but not damaging the film from the beginning.

Although the above description has been made of an example using the XeCl excimer laser as the optical energy or electromagnetic wave energy, any energy source is usable if the energy irradiation time is within several tens seconds and the irradiation is made to only a portion of the substrate. For example, it is also appropriate to use various lasers such as an ArF excimer laser, an XeF excimer laser, a KrF excimer laser, a YAG laser, a carbon dioxide laser, and a dye laser, or to use lamps such as an arc lamp and a tungsten lamp. In the case of conducting the arc lamp irradiation, the lamp output is set to be above 0.1 kW/cm², and the irradiation time is set to be approximately 0.1 second to approximately one minute, by which conditions the crystallization of the semiconductor film advances. For this crystallization, the irradiation time is short and a local heat treatment is taken to the whole substrate, and hence the deformation and crack of the substrate do not occur. In the case of the prior a-Si film prepared by the PECVD method, even according to the furnace-SPC method, the heat treatment at approximately 450°C is indispensable before the crystallization in order to avoid the rapid discharge of hydrogen. In the case of the semiconductor film according to this invention, the heat treatment before the crystallization is unnecessary in the crystallization according to not only the melt crystallizing method but also the furnace-SPC method, the RTA method or the VST-SPC method.

### Embodiments

### (First Embodiment)

A description will be made hereinbelow of a semiconductor film according to this invention and one example of forming it according to the PECVD method. The PECVD apparatus is the same as that stated in detail in the chapter (3), and after a surface protective film being an insulating material such as a silicon oxide film is provided at at least a portion of the substrate surface, a semiconductor film is formed on this surface protective film.

A glass substrate (OA-2) with a dimension of 360 mm x 475 mm x 1.1 mm is placed within the PECVD apparatus where the temperature of the lower flat plate electrode 203 is maintained to be 380°C. The recipe after the installation of the substrate within the PECVD apparatus reaction furnace is as follows.

### (Preheating)

time : t = 300s
silane flow rate : SiH₄ = 100 SCCM
argon flow rate : Ar = 3000 SCCM
high-frequency wave output : RF = 0W (no plasma)
pressure : P = 1.5 Torr
distance between electrodes : S = 37.1 mm
lower flat plate electrode temperature : Tsus = 380°C

### (Film Formation)

time : t = 164s
silane flow rate : SiH₄ = 100 SCCM
argon flow rate : Ar = 3000 SCCM
high-frequency wave output : RF = 600W (0.228 W/cm²)
pressure : P = 1.5 Torr
distance between electrodes : S = 37.1 mm
lower flat plate electrode temperature : Tsus = 380°C
substrate surface temperature : Tsub = 349°C

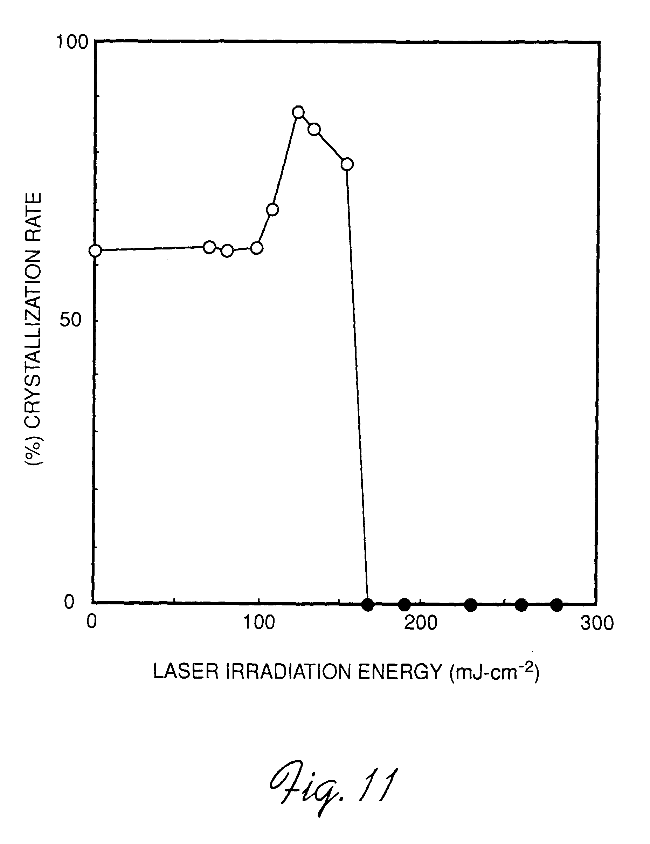

The deposit speed of the semiconductor under such conditions was 0.365 nm/s, and the thickness of the semiconductor film was 60 nm. In addition, the hydrogen concentration in the silicon film was 10.39 atom% when being measured by the heat desorption gas spectroscopy (TDS). According to the observation by a transmission type electron microscope, this silicon film has a pillar-like structure. Fig. 9 shows the spectrum of this silicon film measured by the infrared absorption spectroscopic method. It is found from Fig. 9 that the absorption peak intensity at the vicinity of 2090 cm⁻¹ is higher than that at the vicinity of 2000 cm⁻¹. Further, Fig. 10 shows a Raman spectroscopic measurement result of this silicon film. It is found that a Raman shift from the crystal component appears at the vicinity of 520 cm⁻¹, and the silicon film of this example is a mixed crystal.

### Second Embodiment

The semiconductor film obtained in the first embodiment is exposed to the laser irradiation in the as-deposited state without being heat-treated. The result is shown in Fig. 11 which is the same as Fig. 8 in a way of looking. The irradiation laser light is obtained from an XeCl excimer laser whose wavelength is 308 nm, and its half band width is approximately 45ns. The beam has a rectangular configuration of about 1 cm x 1 cm, and the laser irradiation was made once at each energy. It is found from Fig. 11 that the semiconductor film obtained in the first embodiment can clearly be crystallized if the laser energy density is between approximately 110 mJ·cm⁻² to 160 mJ·cm⁻². In the case of this semiconductor film, when being treated according to the one-stage laser irradiation method, the crystallization rate reaches a maximum of 88% when the energy density is 125 mJ·cm⁻², thus providing a high-quality crystalline semiconductor film. As shown in this second embodiment, if using the semiconductor film according to this invention, it is possible to readily manufacture a high-quality polycrystal semiconductor film with a high crystallization rate with simple laser irradiation and with a relatively low laser energy density, with the heat treatment for the removal of hydrogen which has been carried out being unnecessary.

### Third Embodiment

The semiconductor film obtained in the first embodiment is exposed to the laser irradiation in the as-deposited state without being heat-treated, thus forming a crystalline semiconductor film to produce a thin-film semiconductor device where the crystalline semiconductor film is used as an active layer of a TFT. This will be described with reference to Fig. 3. First, a surface protective film 102 being a silicon oxide film is formed on a large-sized substrate 101 with a dimension of 360 mm x 475 mm according to PECVD method, and an intrinsic silicon film is continuously formed on this surface protective film according to the method of the first embodiment without a vacuum state being broken. The thickness of the surface protective film 102 is 300 nm and the thickness of the semiconductor film is 60 nm. The semiconductor film thus obtained allows its melt crystallization to advance by the laser irradiation in the as-deposited state without the conduct of the heat treatment. The irradiation laser light is emitted from an XeCl excimer laser whose wavelength is 308 nm, and its half band width is approximately 45 ns. Further, the laser light energy density is 140 mJ·cm⁻². The laser irradiation is conducted in the atmosphere. The substrate temperature at the laser irradiation is a room temperature of approximately 25°C. In the case of the semiconductor film thus crystallized, the crystallization rate was 93% when being measured by the wavelength distributed type ellipsometry, and the film thickness was 55 nm. A sharp peak whose half band width is approximately 4.7 cm⁻¹ appears at the vicinity of 515.9 cm⁻¹ indicating the Raman shift from the crystal component according to the Raman spectroscopic measurement, which shows the production of a high-quality film with an extremely high crystalline. In addition, according to a transmission type electron microscopic observation, this semiconductor film is made up of crystal particulates the diameter of which is approximately 180 nm to 400 nm. After the completion of the crystallizing process, this crystalline semiconductor film is patterned, and a semiconductor film 103 is formed which becomes an active layer of a transistor afterwards ((a) of Fig. 3).

Subsequently, a gate insulating film 104 is formed according to the PECVD method ((b) of Fig. 3). The gate insulating film being a silicon oxide film is formed at a substrate surface temperature of 350°C to have a thickness of 120 nm with TEOS (Si-(O-CH₂-CH₃)₄) and oxygen (O₂) being used as the raw material gas.

Following this process, a tantalum (Ta) thin-film serving as a gate electrode 105 is deposited according to the sputtering method. The substrate temperature at the sputtering is 150°C and the thickness of the film is 500 nm. After the deposit of the tantalum thin-film acting as the gate electrode, subsequently impurity ions 106 are injected into the semiconductor film to produce a source-drain area 107 and a channel area 108 ((c) of Fig. 3). At this time, the gate electrode serves as a mask for the ion injection, the channel has a self-matching structure constructed only under the gate electrode. The impurity ion injection is conducted using a mass non-separating type ion injector. The phosphorus atom concentration in the source-drain area is approximately 3 x 10²⁰ cm⁻³.

Then, an interlayer insulating film 109 being a silicon oxide film is formed using TEOS according to the PECVD method. The substrate surface temperature is 350°C at the formation of the interlayer insulating film, and the film thickness is 500 nm, Thereafter, the heat treatment is carried out at 350°C for one hour to activate the injected ions.

Subsequently, a contact hole is made in the source-drain and aluminium (Al) is deposited according to the sputtering method. The substrate temperature at the sputtering is 150°C and the film thickness is 500 nm. a source-drain leading electrode 110 and an aluminium thin-film being a wiring are patterned, thus completing a thin-film semiconductor device ((d) of Fig. 3).

The transistor characteristic of the thin-film semiconductor device thus trial-manufactured was measured, the result being that, if the source-drain current Ids is defined as the on current ION in the case that the transistor is turned on under the conditions of the source-drain voltage Vds = 4V and the gate voltage Vgs = 10V, the on current ION was INO = (49.5 + 8.3, - 6.3) x 10⁻⁶A with a confidence coefficient of 95%. In addition, when the transistor is turned on under the conditions of Vds = 4V and Vgs = 0V, the off current IOFF was IOFF = (1.95 + 0.70, - 0.49) x 10⁻¹²A. In this instance, the measurement was made to a transistor, which has a channel section length L = 10 µm and a width W = 10 µm, at a temperature of 25°C. The electron mobility obtained from a saturated current region was µ = 82.4 ± 11.75 cm²·V⁻¹·S⁻¹, and the threshold voltage was Vth = 2.25 ± 0.17V. Thus, according to this invention, it was possible to produce an extremely excellent thin-film semiconductor device having a high mobility which is approximately 100 times that of the prior a-Si TFT under the conditions that the maximum process temperature (350°C) is the same as that of the prior a-Si TFT and the manufacturing process is similar thereto (no need for crystallization process).

As described above, according to this invention, a crystalline semiconductor film made of a crystalline silicon film is easily formable at a low temperature of below approximately 400°C, and the quality of the crystalline semiconductor film sharply improves, and the mass production is stably possible. More specifically, the effects are as follows.

### (Effect 1)

Since the process temperature is as low as below 400°C, a cheap glass is usable, thereby lowering the product price. In addition, the distortion due to the dead weight of the glass itself is avoidable, whereby a high-quality crystalline semiconductor film is formable over a wide area.

### (Effect 2)

A uniform laser irradiation is possible over the whole of the substrate. As a result, the uniformity is improved at every lot and a stable production is possible.

Thus, in a case where this invention is applied to an active matrix liquid crystal display, a cheap glass substrate or the like is usable and a large-sized high-quality LCD is easily and stably producible. In addition, in a case where this invention is applied to another electric unit, the deterioration of elements and others due to heat is reducible. Accordingly, this invention can show a large effect which easily improves the performance of electronic devices such as an active matrix liquid crystal display, a solar battery and an integrated circuit and further lowers the price thereof.

It should be understood that the foregoing relates to only preferred embodiments of the present invention, and that it is intended to cover all changes and modifications of the embodiments of the invention herein used for the purposes of the disclosure, which do not constitute departures from the spirit and scope of the invention.

## Claims

1. A method of forming a crystalline semiconductor film on an insulating material of a substrate, said substrate at least having said insulating material as a portion of its surface, said method comprising:
a first step of using a chemical substance containing an element for said semiconductor film as a raw material gas and further using an argon (Ar) as an additional gas to deposit said semiconductor film in accordance with a plasma chemical vapor phase deposit (PECVD) method; and
a second step of improving a crystallization of said semiconductor film.

2. A method of forming a crystalline semiconductor film on an insulating material of a substrate as claimed in claim 1, wherein the second step comprises applying one of an optical energy and electromagnetic wave energy to said semiconductor film.

3. A method of forming a crystalline semiconductor film on an insulating material of a substrate as claimed in claim 1 or claim 2, wherein said semiconductor film is a silicon film and a silane (SiH₄, Si₂H₆, Si₃H₈) is used as said raw material gas.

4. A method of forming a silicon film as a crystalline semiconductor film on an insulating material of a substrate, said substrate at least having said insulating material as a portion of its surface, said method comprising:
a first step of forming said silicon film in which an absorption peak intensity at the vicinity of 2090 cm⁻¹ is higher than an absorption peak intensity at the vicinity of 2000 cm⁻¹ when measurement of the absorption peak intensity is taken in accordance with an infrared-absorption spectroscopic method; and
a second step of improving a crystallization of said silicon film.

5. A method of forming a silicon film as a crystalline semiconductor film on an insulating material of a substrate as claimed in claim 4, wherein the first step is conducted in accordance with a plasma chemical vapor phase deposit (PECVD) method.

6. A method of forming a silicon film as a crystalline semiconductor film on an insulating material of a substrate as claimed in claim 4 or claim wherein the second step comprises applying one of an optical energy and electromagnetic wave energy to said silicon film.

7. A method of forming a crystalline semiconductor film on an insulating material of a substrate, said substrate at least having said insulating material as a portion of its surface, said method comprising:
a first step of depositing said semiconductor film which has a pillar-like configuration; and
a second step of improving a crystallization of said pillar-like semiconductor film.

8. A method of forming a crystalline semiconductor film on an insulating material of a substrate as claimed in claim 7, wherein the first step is conducted in accordance with a plasma chemical vapor phase deposit (PECVD) method.

9. A method of forming a crystalline semiconductor film on an insulating material of a substrate as claimed in claim 7 or claim 8, wherein the second step comprises applying one of an optical energy and electromagnetic wave energy to said pillar-like semiconductor film.

10. A method of forming a crystalline semiconductor film on an insulating material of a substrate as claimed in any one of claims 7 to 9, wherein said semiconductor film is a silicon film.
